Europäisches Patentamt

(19) European Patent Office

Office européen des brevets

(11) Numéro de publication: **0 106 716**
**A1**

(12) # DEMANDE DE BREVET EUROPEEN

(21) Numéro de dépôt: 83401673.5

(22) Date de dépôt: 17.08.83

(51) Int. Cl.³: **H 05 K 13/06**
**B 23 K 20/10**

(30) Priorité: 27.08.82 FR 8214735

(43) Date de publication de la demande:
25.04.84 Bulletin 84/17

(84) Etats contractants désignés:
BE DE GB IT NL

(71) Demandeur: THOMSON-CSF
173, Boulevard Haussmann
F-75379 Paris Cedex 08(FR)

(72) Inventeur: Lacruche, Bernard
Thomson-CSF SCPI 173 bld Haussmann
F-75379 Paris Cedex 08(FR)

(72) Inventeur: Fromont, Thierry
Thomson-CSF SCPI 173 bld Haussmann
F-75379 Paris Cedex 08(FR)

(74) Mandataire: Wang, Pierre et al,
THOMSON-CSF SCPI 173, Bld Haussmann
F-75379 Paris Cedex 08(FR)

(54) Procédé de câblage automatisé à panne vibrante, et machine de câblage utilisant un tel procédé.

(57) L'invention se rapporte aux procédés et dispositifs de brasage pour lesquel l'énergie nécessaire à la brasure est apportée par une panne chauffante (6).

L'invention a pour objet d'animer la panne chauffante (6) d'un mouvement vibrant qui permet d'obtenir un auto-nettoyage de la panne et une action abrasive sur le vernis (5) des fils à souder (4).

L'invention s'applique notamment aux machines de câblage automatisé.

FIG.2

EP 0 106 716 A1

# PROCEDE DE CABLAGE AUTOMATISE A PANNE VIBRANTE
# ET MACHINE DE CABLAGE UTILISANT UN TEL PROCEDE

La présente invention se rapporte à un procédé de câblage automatisé ainsi qu'aux machines de câblage automatisé.utilisant un tel procédé.

Des machines de câblage automatisé par conducteurs isolés soudés ont été développées récemment. Elles utilisent des procédés qui ont été conçus pour réduire les délais et les coûts d'implantation des circuits. L'originalité de ces procédés est que les circuits d'interconnexion sont réalisés de façon complètement automatique par une seule machine relativement simple et qu'ils sont parfaitement compatibles avec les circuits imprimés. Ces caractéristiques devraient assurer à cette technique une large diffusion.

Cependant, le problème majeur qui se pose aux machines utilisant ces procédés est la mauvaise reproductibilité des joints brasés, voire quelquefois l'absence de brasage.

Afin de pallier ces inconvénients, l'invention propose d'animer la panne chauffante des dispositifs de brasure automatisés d'un mouvement vibrant qui permet d'obtenir un auto-nettoyage de la panne et une action abrasive sur le vernis des fils émaillés à souder sur les circuits.

L'invention a donc pour objet un procédé de câblage automatisé de cartes comportant des éléments conducteurs sur un matériau susceptible de se dégrader sous l'action de la chaleur, lesdits éléments étant destinés à être reliés à des fils de câblage recouverts d'émail, lesdits fils étant déroulés par une tête de pose et étant connectés auxdits éléments conducteurs par brasage local au moyen d'une panne chauffante, caractérisé en ce que le brasage s'effectue en présence d'un mouvement relatif de ladite panne par rapport audit fil, ce mouvement étant destiné à empêcher l'encrassement de la panne par les produits de décomposition engendrés par ledit brasage.

L'invention a également pour objet une machine de câblage automatisé utilisant un tel procédé.

L'invention sera mieux comprise au moyen de la description ci-après et des figures annexées parmi lesquelles :

- la figure 1 est une vue partielle très grossie d'une étape de brasage à l'aide d'une machine utilisant un procédé de brasage automatisé ;

- les figures 2 et 3 sont des vues partielles très grossies d'une étape de brasage par une machine utilisant une panne selon l'invention ;

- la figure 4 représente un exemple de mise en oeuvre d'un mouvement vibrant à une panne ;

- les figures 5 et 6 sont des vues en coupe, sous des angles différents d'une brasure ainsi réalisée.

La description qui va suivre portera principalement sur une machine de câblage utilisant un procédé de câblage automatisé, mais l'invention peut s'appliquer sur toute machine à souder utilisant une panne chauffante et même à des fers à souder ordinaires.

Ce genre de machine permet de réaliser des soudures sur des cartes support classiques, par exemple en verre époxy avec pastilles et trous métallisés servant d'éléments conducteurs. Des fils, qui remplacent les pistes conductrices des circuits imprimés classiques, sont déposés automatiquement. Les fils d'interconnexion sont collés sur un adhésif thermo-adhérent dont on a enduit la carte. Leurs extrémités sont soudées sur des plots étamés solidaires des pastilles à interconnecter. Les opérations de dépôt et de soudure des fils sont réalisées par une machine automatique comportant :

- une baie de commande pilotée par un lecteur de ruban ;

- une table YX entraînée par deux moteurs pas à pas dont la course permet de câbler les plus grandes cartes usuelles (400 X 500 mm$^2$) ;

- de une à quatre têtes de câblage reliées à des organes de commande électromécaniques et oléopneumatiques actionnés par la baie. Chaque tête assure les opérations suivantes : dévidage et collage du fil, dénudage, fluxage et soudure du fil, enfin découpe du fil en fin de liaison.

Une fois le tracé terminé, une deuxième couche d'adhésif de protection est appliquée sur la carte. L'ensemble est ensuite étuvé pour polymériser les adhésifs.

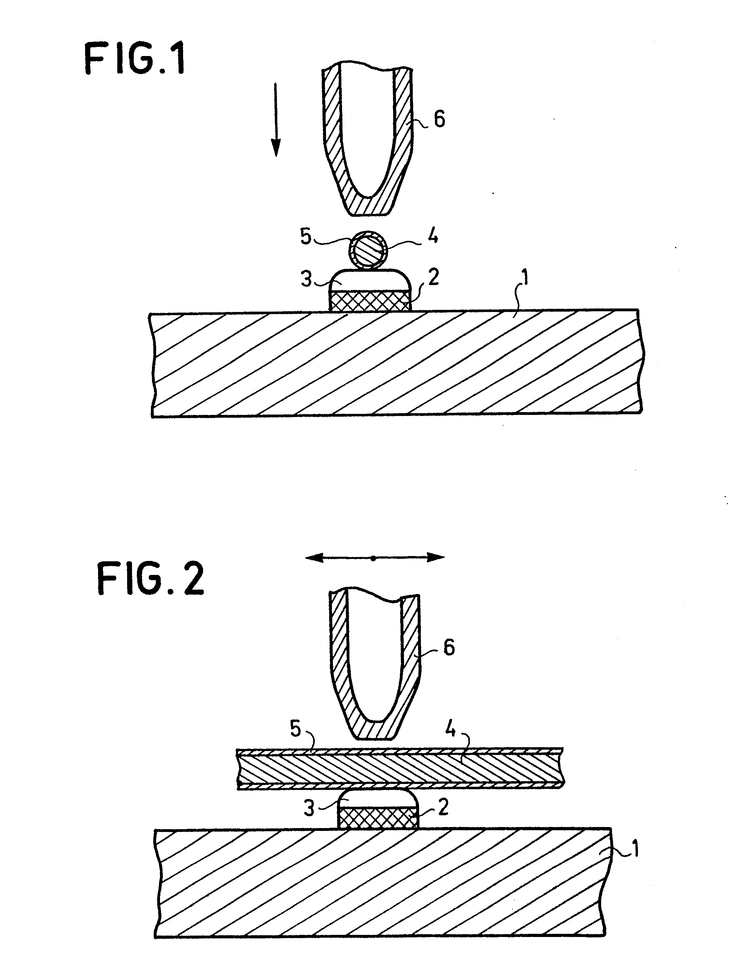

La figure 1 est une vue partielle très grossie d'une étape de brasage à l'aide d'une machine utilisant un procédé de câblage automatisé. On remarque, sur cette figure, une carte support 1, par exemple en verre époxy, sur laquelle adhère une pastille 2 en cuivre d'environ 35 microns d'épaisseur.

Cette pastille a été recouverte d'un élément de brasure 3 (par exemple un alliage plomb-étain) qui peut être déposée par la technique de la vague ou électrolytiquement. Un conducteur représenté en coupe transversale et se présentant sous forme d'un fil 4 recouvert d'un vernis 5 est dévidé par la machine, collé sur la carte 1 et vient toucher la pastille 2 recouverte de l'élément de brasure 3 pour assurer une liaison électrique entre cette pastille et un autre circuit ou connexion.

Pour réaliser la brasure, une panne chauffante 6 vient se placer au-dessus des éléments à souder et se déplace dans le sens de la flèche pour toucher le fil. Les pannes utilisées sont très fines puisque certaines machines peuvent souder des fils d'un diamètre inférieur à 50 microns. L'extrémité des pannes, qui vient en contact avec le fil à souder, peut avoir une largeur de quelques dixièmes de millimètre. La pression exercée par la panne sur le fil est inférieure à 100 g afin de ne pas l'écraser. L'énergie nécessaire à la réalisation du joint brasé est apportée par l'échauffement de la panne. Le transfert de chaleur vers l'alliage de brasage s'effectue à travers un milieu mal défini et qui évolue dans le temps. En effet, la chaleur de la panne (en moyenne 250 à 280° C) décompose la couche de vernis 5 qui sert d'isolant pour le fil 4. Le dénudage du fil se fait donc sous l'influence de la chaleur et les produits de décomposition du vernis (qui peut être du polyuréthane) servent de flux de brasure. Cependant, cette décompostion laisse des résidus qui se déposent à l'extrémité de la panne. D'autres éléments apparaissent également comme des traces de carbone ou d'oxyde d'étain. Ces résidus nuisent au bon fonctionnement de la machine car ils s'opposent au transfert de chaleur. Il est connu, dans des applications bien particulières, de réaliser certaines soudures avec un fer à souder muni d'une panne vibrante. Par exemple, dans le cas du brasage de l'aluminium, on utilise un tel fer pour casser la couche d'alumine qui recouvre naturellement les pièces en aluminium et qui est un très bon isolant thermique, afin que la brasure puisse prendre sur le métal. Dans ce cas particulier, le mouvement imposé à la panne sert uniquement à briser la couche d'alumine et la chaleur dégagée par la panne doit être relativement élevée.

Dans le cas de machines de soudage automatisé de circuits imprimés, le problème est quelque peu différent. Ce n'est pas la présence d'alumine qui nuit au bon fonctionnement de la machine, mais les résidus de décomposition du vernis qui recouvre le fil à souder. Pratiquement, pour venir à bout des résidus, il faudrait augmenter la température de la panne de plusieurs centaines de degrés. En plus de l'apport de chaleur à fournir, cette température risquerait de décoller les pastilles et de nuire à la qualité des soudures.

La solution faisant l'objet de la présente invention consiste à doter la panne d'un mouvement vibrant qui permet d'obtenir un auto-nettoyage de la panne en même temps qu'une action abrasive sur le vernis. L'existence d'un mouvement vibrant de la panne ainsi que le frottement de cette panne contre le fil à souder provoquent l'élimination des dépôts de résidus sur la panne au fur et à mesure qu'ils apparaissent.

La figure 2 est une vue partielle très grossie d'une étape de brasure par une machine utilisant une panne selon l'invention. Elle reprend tous les éléments de la figure 1 mais le fil à souder a été représenté suivant une coupe longitudinale. La panne est mise en contact avec le fil au niveau de la brasure à effectuer et est animée d'un mouvement vibratoire parallèle au fil 4 comme l'indique la flèche. L'amplitude des vibrations peut être de quelques dizaines de microns. La mise en vibration de la panne peut s'effectuer à sa pose sur le fil et s'arrêter au retrait de la panne, la force de réaction du fil sur la panne étant suffisante pour déclencher un système vibrant ; ceci afin de ne pas gêner le positionnement des points de soudure par la machine. On peut également pour des systèmes plus grossiers, comme des fers à souder, laisser le mouvement vibratoire en continu.

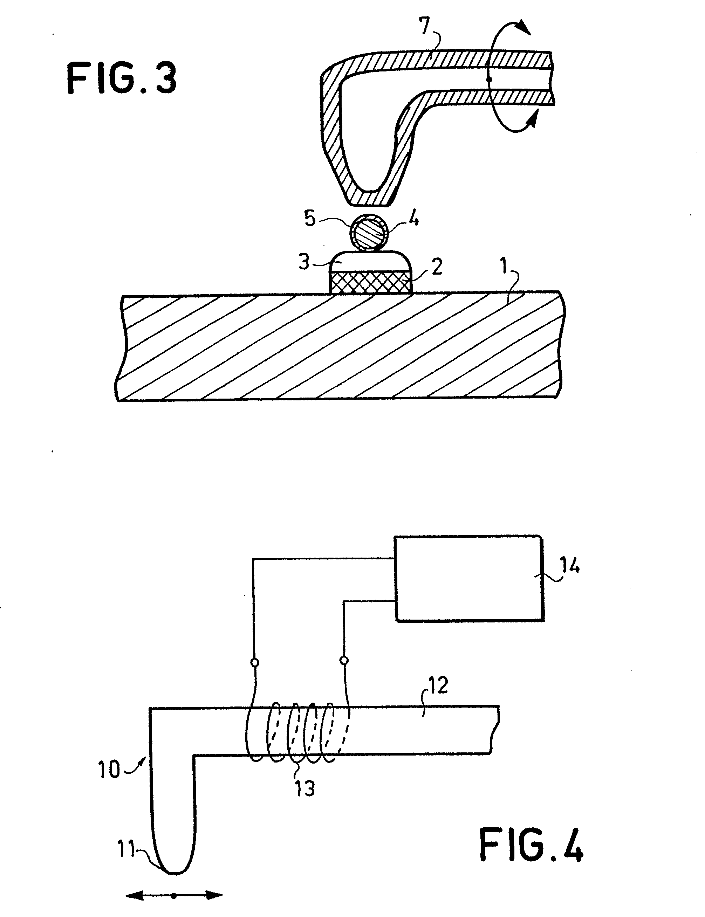

Une autre façon de procéder est révélée par la figure 3. Comme les figures précédentes, elle représente une vue partielle en coupe d'une étape de brasure exécutée selon une variante de l'invention. Dans cette figure, les mêmes références désignent les mêmes objets que dans les figures précédentes. La panne 7 est différente de celles décrites antérieurement afin de pouvoir convertir un mouvement vibrant rotatoire imprimé à la panne en mouvement vibrant parallèle au fil 4.

Les mouvements vibratoires imposés aux pannes peuvent être provoqués de différentes manières par des transducteurs électromécaniques. On peut, par exemple dans le cas de mouvements en translation, placer la panne dans le champ d'une bobine d'induction comme le représente la figure 4. Sur cette figure, on aperçoit une panne 10 en forme de L. L'une des extrémités du L, l'extrémité 11, est la partie active qui réalise la soudure. La branche 12 de la panne est reliée à des moyens de chauffage non représentés. Cette branche est placée dans le champ d'une bobine d'induction 13 alimentée par un générateur 14 de tension alternative fonctionnant par exemple à la fréquence du secteur. On peut également employer comme moyens vibrants un générateur d'ultrasons du genre magnétostrictif ou céramique fonctionnant entre 10 et 20 kHz. Dans le cas d'un mouvement vibrant rotatoire, on peut utiliser de petits moteurs qui sont conçus spécialement pour délivrer ce genre de mouvement (moteur à mouvement alternatif).

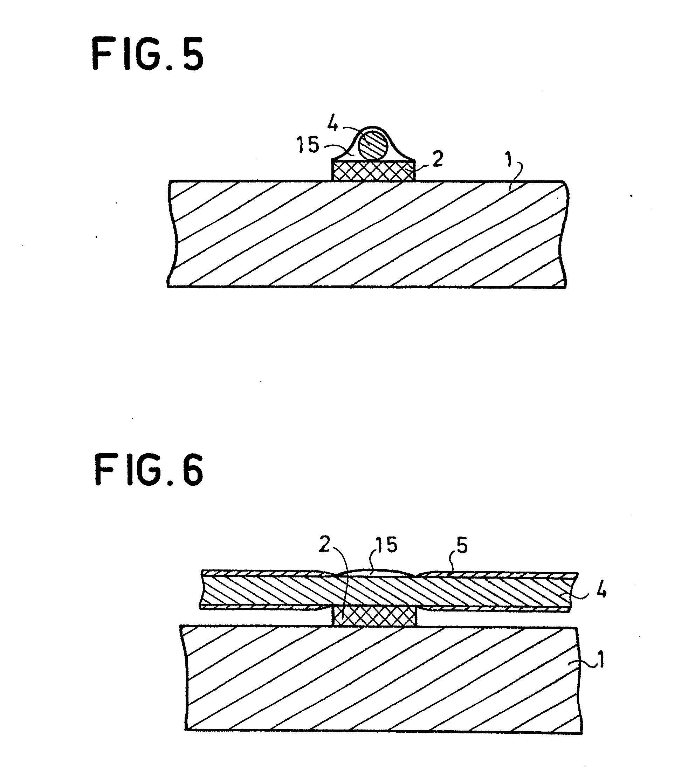

Les figures 5 et 6 sont des vues en coupe, sous des angles différents, d'une brasure ainsi réalisée. Dans la figure 5, le fil 4 se présente en coupe transversale. L'alliage de soudure 15 réalise une liaison efficace entre le fil 4 et la pastille 2. Au niveau de la brasure le vernis a disparu. La figure 6 est un autre aspect de la brasure représentée à la figure 5. Le fil 4 se présente maintenant en coupe transversale. Cette figure a l'avantage de montrer la couche de vernis 5 qui subsiste sur les parties du fil non brasées.

L'invention permet de résoudre simplement un problème important posé par les machines à souder automatiques. En plus de l'amélioration de la qualité des joints brasés, la diminution de la résistance thermique entre la panne et le dépôt de brasure contribue à diminuer la température de brasage, à diminuer la pression exercée sur la panne et à régulariser la transmission calorifique.

## REVENDICATIONS

1. Procédé de câblage automatisé de cartes comportant des éléments conducteurs (2) sur un matériau (1) susceptible de se dégrader sous l'action de la chaleur, lesdits éléments étant destinés à être reliés à des fils de câblage (4) recouverts d'émail (5), lesdits fils étant déroulés par une tête de pose et étant connectés auxdits éléments conducteurs par brasage local au moyen d'une panne chauffante (6), caractérisé en ce que le brasage s'effectue en présence d'un mouvement relatif de ladite panne par rapport audit fil, ce mouvement étant destiné à empêcher l'encrassement de la panne par les produits de décomposition engendrés par ledit brasage.

2. Machine de câblage automatisé, caractérisée en ce qu'elle utilise un procédé selon la revendication 1.

3. Machine de câblage automatisé selon le revendication 2, caractérisée en ce que ledit mouvement relatif est un mouvement vibratoire.

4. Machine de câblage automatisé selon la revendication 3, caractérisée en ce que ledit mouvement vibratoire consiste en un va-et-vient de ladite panne (6) sur ledit fil (4).

5. Machine de câblage automatisé selon l'une quelconque des revendications 2 à 4, caractérisée en ce que ledit mouvement relatif n'a lieu que lorsque ladite panne prend contact avec ledit fil.

6. Machine de câblage automatisé selon l'une quelconque des revendications 3 à 5, caractérisée en ce que ledit mouvement vibratoire est engendré par un transducteur électromécanique.

7. Machine de câblage automatisé selon la revendication 6, caractérisée en ce que ledit transducteur comprend une bobine d'induction (13).

8. Machine de câblage automatisé selon la revendication 6, caractérisée en ce que ledit transducteur comprend un générateur d'ultrasons.

9. Machine de câblage automatisé selon la revendication 6, caractérisée en ce que ledit transducteur comprend un moteur à mouvement alternatif.

FIG.1

FIG.2

FIG.3

FIG.4

FIG.5

FIG.6

Office européen
des brevets

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. ³) |
|---|---|---|---|
| Y | US-A-3 675 840  (TOWELL) <br> * Résumé; figures * | 1,2 | H 05 K   13/06 <br> B 23 K   20/10 |
| Y | IBM TECHNICAL DISCLOSURE BULLETIN, vol. 12, no. 4, septembre 1969, New York (US) R.J. SURTY et al.:"Method of bonding", page 547 | 1-3,8 | |
| Y | WELDING JOURNAL, vol. 57, no. 2, février 1978 A.P. HULST et al.:"Ultrasonic bonding of insulated wire is carried out using a preprogrammed cycle of clamping force and vibration amplitude so that successive cleaning and welding phases are realized in one operation", pages 19-25 | 1 | |
| X | PATENTS ABSTRACTS OF JAPAN, vol. 6, no. 21 (E-93) (899), 6 février 1982, page 119 & JP - A - 56 141 754 (MITSUBISHI DENKI K.K.)  (05-11-1981) | 1,3,4, 8 | |
| A | US-A-3 384 283  (MIMS) <br><br> *  Figures; colonne 1, lignes 26-29; colonne 2, ligne 70 - colonne 3, ligne 23; colonne 4, ligne 72 - colonne 5, ligne 5; colonne 5, lignes 48-68 * | 1,3,6, 7,8 | |

DOMAINES TECHNIQUES RECHERCHES (Int. Cl. ³)

H 05 K
H 01 L
B 23 K
H 02 K

-/-

Le présent rapport de recherche a été établi pour toutes les revendications

| Lieu de la recherche <br> LA HAYE | Date d'achèvement de la recherche <br> 06-12-1983 | Examinateur <br> PEETERS S. |
|---|---|---|

**0106716**

Office européen
des brevets

**RAPPORT DE RECHERCHE EUROPEENNE**

Numéro de la demande

'EP 83 40 1673

| DOCUMENTS CONSIDERES COMME PERTINENTS | | | Page 2 |
|---|---|---|---|
| Catégorie | Citation du document avec indication, en cas de besoin, des parties pertinentes | Revendication concernée | CLASSEMENT DE LA DEMANDE (Int. Cl. ³) |
| A | FR-A-2 118 750 (PHILIPS) | | |
| A | DE-A-2 149 748 (HONEYWELL) | | |
| A | DE-A-1 490 632 (SIEMENS) | | |
| A | US-A-3 767 101 (GENRICH) | | |
| A | US-A-3 747 198 (BENSON) | | |
| A | FR-A-1 428 181 (THOMSON-HOUSTON) | | DOMAINES TECHNIQUES RECHERCHES (Int. Cl. ³) |

Le présent rapport de recherche a été établi pour toutes les revendications

| Lieu de la recherche LA HAYE | Date d'achèvement de la recherche 06-12-1983 | Examinateur PEETERS S. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82